# EUROPEAN PATENT APPLICATION

(11) **EP 4 561 277 A1**
(43) Date of publication of application: **28.05.2025**
(21) Application number: 23871482.8
(22) Date of filing: 07.08.2023
(51) Int. Cl.: H05K 5/02, H01R 13/52, H05K 1/11

(54) **ELECTRONIC DEVICE**

(30) Priority: 30.09.2022 JP 2022158129
(71) Applicant: Japan Aviation Electronics Industry, Limited, Tokyo 150-0043 (JP)
(72) Inventor: NAKAMURA, Kazunobu, Tokyo 150-0043 (JP); LI, Teng, Tokyo 150-0043 (JP); IWAO, Naoki, Tokyo 150-0043 (JP)
(74) Representative: MERH-IP Matias Erny Reichl Hoffmann Patentanwälte PartG mbB
(86) International application number: PCT/JP2023/028721
(87) International publication number: WO 2024/070240

(57) **Abstract**

Water entering a penetration hole in a printed wiring board is actively discharged. A connector unit 100 includes a printed wiring board 30 including a penetration hole 31b that has a circular shape and that penetrates an upper surface 30A and a lower surface 30B, an electronic component 40 mounted on the upper surface 30A, a water guide member 20 that is disposed on the lower surface 30B side and that at least partially faces the penetration hole 31b, and a case 70. Apart, of the water guide member 20, facing the penetration hole 31b has a protruding shape (a distal end part 203) or includes a surface (a surface 231b) that is sloped away from the lower surface 30B, and the water guide member 20 is disposed in such a way that the shortest distance to a centroid of a shape of an end part 31b2 is smaller than a radius of the largest circle that is insertable in the shape of the end part 31b2.

## Description

### [TECHNICAL FIELD]

The present invention relates to a drain structure of an electronic device.

### [BACKGROUND ART]

Some prior art electronic devices having a drain structure are capable of discharging water to outside even if water enters inside a case (for example, see Patent literature 1). FIGS. 1 and 2 are diagrams showing the drain structure of the prior art. The prior art is a vehicle-mounted device that is embedded in an instrument panel of a vehicle and that is kept installed while being tilted such that an operation screen side that is exposed inside a vehicle interior is lower in a side view. A vehicle-mounted device 1 includes a circuit board 12 where a connector 121 for connecting a cable from outside is mounted, and a case 16 in which the circuit board is housed. Furthermore, the case includes, on an opposite side from the operation screen, a rear wall 164 in which an opening portion 168 for exposing the connector is formed. The case includes a bottom wall 162 in which a drain hole 166 is formed, the bottom wall extending from a lower part of the rear wall toward the operation screen side.

### [PRIOR ART LITERATURE]

### [PATENT LITERATURE]

Patent literature 1: Japanese Patent Application Laid-Open No. 2021-154824

### [SUMMARY OF THE INVENTION]

### [PROBLEMS TO BE SOLVED BY THE INVENTION]

However, with respect to the vehicle-mounted device 1 of Patent literature 1, a technique is merely disclosed according to which water guided to the bottom wall 162 is discharged from the drain hole 166. Depending on a mode of use of the electronic device, not all the water reaches the bottom wall 162, and water is possibly retained on other components such as a circuit board, for example.

In many cases, a printed wiring board forming a part of a circuit board includes a penetration hole for positioning an electronic component, for example. Accordingly, when water stays on the printed wiring board, a part of the water may possibly enter the penetration hole. Water entering the penetration hole may be discharged to below the printed wiring board in the form of waterdrops. However, depending on conditions such as a size of a diameter of the penetration hole or an angle of the printed wiring board, there is a problem that water is retained inside the penetration hole in the printed wiring board, thus staying on the printed wiring board and rusting a mounted component such as the connector.

In view of the problem described above, an object of the present invention is to provide an electronic device that allows water entering a penetration hole in a printed wiring board to be actively discharged.

### [MEANS TO SOLVE THE PROBLEMS]

To solve the problem described above, an electronic device according to a present embodiment comprises a printed wiring board including a penetration hole that has a circular shape and that penetrates a first surface and a second surface, an electronic component mounted on the first surface of the printed wiring board, a water guide member disposed on the second surface side of the printed wiring board, the water guide member at least partially facing the penetration hole, and a case that houses the printed wiring board, the electronic component, and the water guide member.

A part, of the water guide member, facing the penetration hole has a protruding shape or includes a surface that is sloped away from the second surface, and the water guide member is disposed in such a way that the shortest distance to a centroid of a shape of an end part of the penetration hole on the second surface side is smaller than a radius of the largest circle that is insertable in the shape of the end part.

### [EFFECTS OF THE INVENTION]

With the electronic device of the present embodiment, the water guide member includes a protruding part that faces the penetration hole or a sloping surface that is at a predetermined angle relative to a penetration direction of the penetration hole, and the water guide member is disposed in such a way that the shortest distance to the centroid of the shape of the end part of the penetration hole on the second surface side is smaller than the radius of the largest circle that is insertable in the shape of the end part, and thus, water entering the penetration hole in the printed wiring board can be actively discharged.

### [BRIEF DESCRIPTION OF THE DRAWINGS]

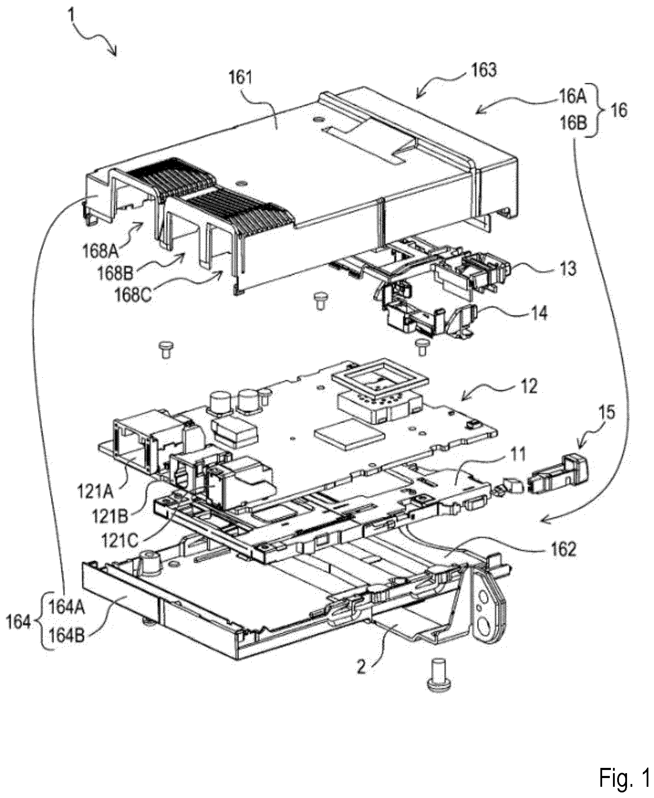

[FIG. 1] FIG. 1 is a diagram for describing a prior art electronic device including a drain structure;

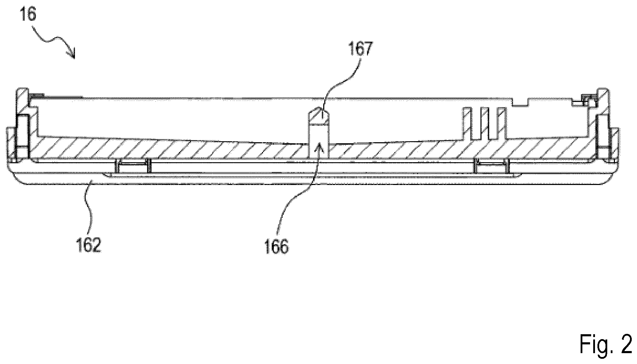

[FIG. 2] FIG. 2 is a diagram for describing the priori art electronic device including the drain structure;
[FIG. 3] FIG. 3A is a perspective view showing an example of a connector unit as an example of an electronic device according to a present embodiment,
FIG. 3B is a side view showing the example of the connector unit as an example of the electronic device according to the present embodiment, and
FIG. 3C is a front view showing the example of the connector unit as an example of the electronic device according to the present embodiment;
[FIG. 4] FIG. 4A is a rear view of the connector unit shown in FIG. 3A and
FIG. 4B is a cross-sectional view taken along a line C-C in FIG. 4A;
[FIG. 5] FIG. 5 is an exploded perspective view of the connector unit shown in FIG. 3A;
[FIG. 6] FIG. 6A is a perspective view showing a printed circuit board 35 of the connector unit shown in FIG. 3A, and FIG. 6B is a side view of a printed wiring board 30 shown in FIG. 6A;
[FIG. 7] FIG. 7A is a perspective view of the printed circuit board 35 where a waterproof sealing member 60 is integrally formed, and FIG. 7B is a cross-sectional view seen from an interface connector 40 side, where a connector unit 100 is cut along a surface including a boundary 30c;
[FIG. 8] FIG. 8A is a rear view showing an example of the connector unit, where a rear surface cover 80 is included and FIG. 8B is a cross-sectional view taken along a line C-C in FIG. 8A;
[FIG. 9] FIG. 9A is a diagram for describing a water guide member 20, and is a drawing showing a region, on a cross-sectional view A-A in FIG. 3C, from a front plate part 74 to a cross-sectional line B-B in FIG. 3B, FIG. 9B is a diagram for describing the water guide member 20, and is a cross-sectional view B-B in FIG. 3B, FIG. 9C is a diagram for describing the water guide member 20, and is a perspective view of FIG. 9B as viewed from upper left, and FIG. 9D is a diagram for describing the water guide member 20, and is a perspective view showing FIG. 9B from a lower left side;
[FIG. 10] FIG. 10 is an enlarged view of a region indicated by a dash-dotted line in FIG. 9A;
[FIG. 11] FIG. 11A is a diagram for describing a water guide member 21, and is a diagram corresponding to FIG. 9A, FIG. 11B is a diagram for describing the water guide member 21, and is a diagram corresponding to FIG. 9B, FIG. 11C is a diagram for describing the water guide member 21, and is a diagram corresponding to FIG. 9C, FIG. 11D is a diagram for describing the water guide member 21, and is a diagram corresponding to FIG. 9D, and FIG. 11E is a diagram for describing the water guide member 21, and is a cross-sectional view E-E in FIG. 11B;
[FIG. 12] FIG. 12A is a diagram for describing a water guide member 22, and is a diagram corresponding to FIG. 9A, FIG. 12B is a diagram for describing the water guide member 22, and is a diagram corresponding to FIG. 9B, FIG. 12C is a diagram for describing the water guide member 22, and is a diagram corresponding to FIG. 9C, FIG. 12D is a diagram for describing the water guide member 22, and is a diagram corresponding to FIG. 9D, and FIG. 12E is a diagram for describing the water guide member 22, and is an enlarged view of a region indicated by a dash-dotted line in FIG. 12D;
[FIG. 13] FIG. 13A is a diagram for describing a water guide member 23, and is a diagram corresponding to FIG. 9A, FIG. 13B is a diagram for describing the water guide member 23, and is a diagram corresponding to FIG. 9B, FIG. 13C is a diagram for describing the water guide member 23, and is a diagram corresponding to FIG. 9C, and FIG. 13D is a diagram for describing the water guide member 23, and is a diagram corresponding to FIG. 9D; and
[FIG. 14] FIG. 14 is an enlarged view of a region indicated by a dash-dotted line in FIG. 13A.

### [DETAILED DESCRIPTION OF THE EMBODIMENTS]

Hereinafter, an embodiment of the present invention will be described with reference to the drawings. In the description, a case where a connector unit is used as an example of an electronic device will be described. However, in the present invention, the type of the electronic device is not limited to the connector unit as long as the electronic device includes a printed wiring board including a penetration hole described later, and application to other electronic devices is also possible. Additionally, in the following description, structural parts having a same function are denoted by a same number, and a redundant description will be omitted.

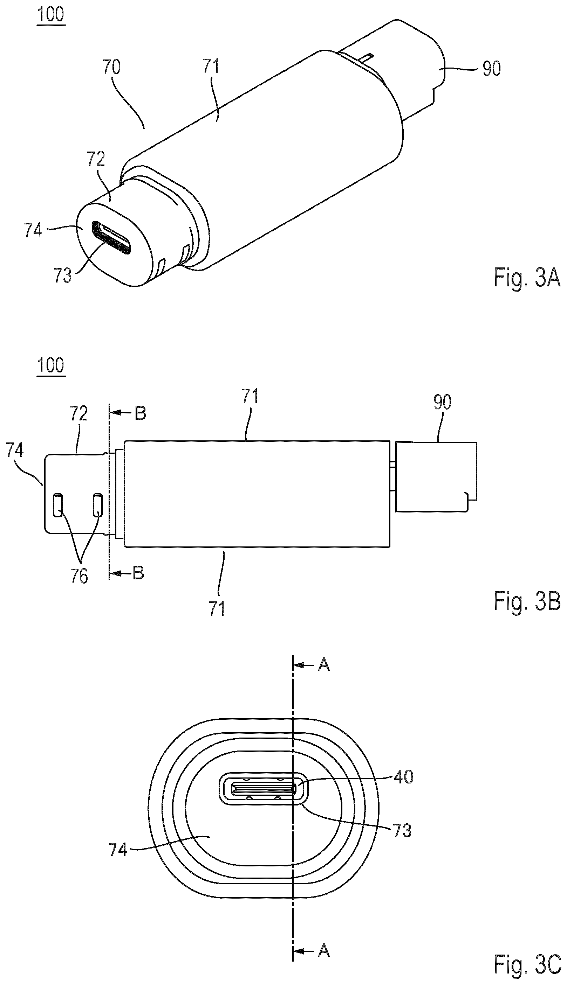

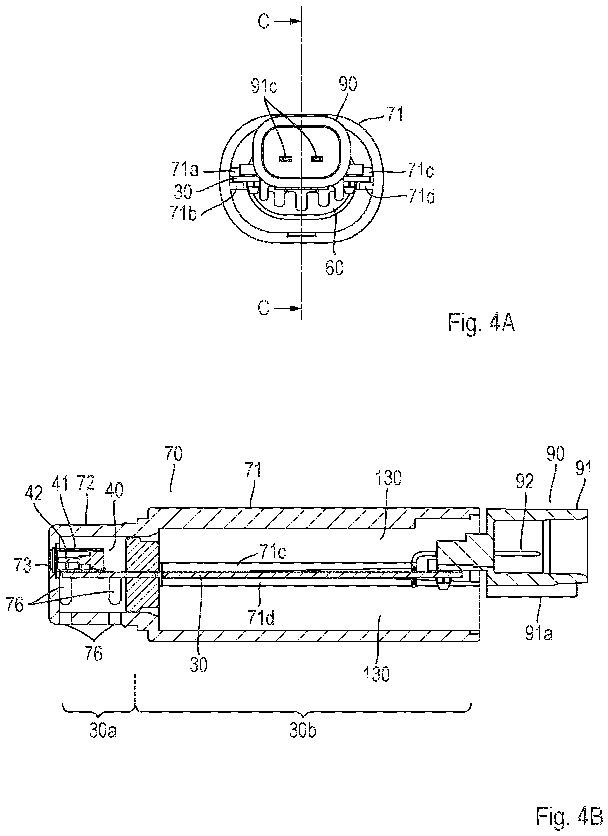

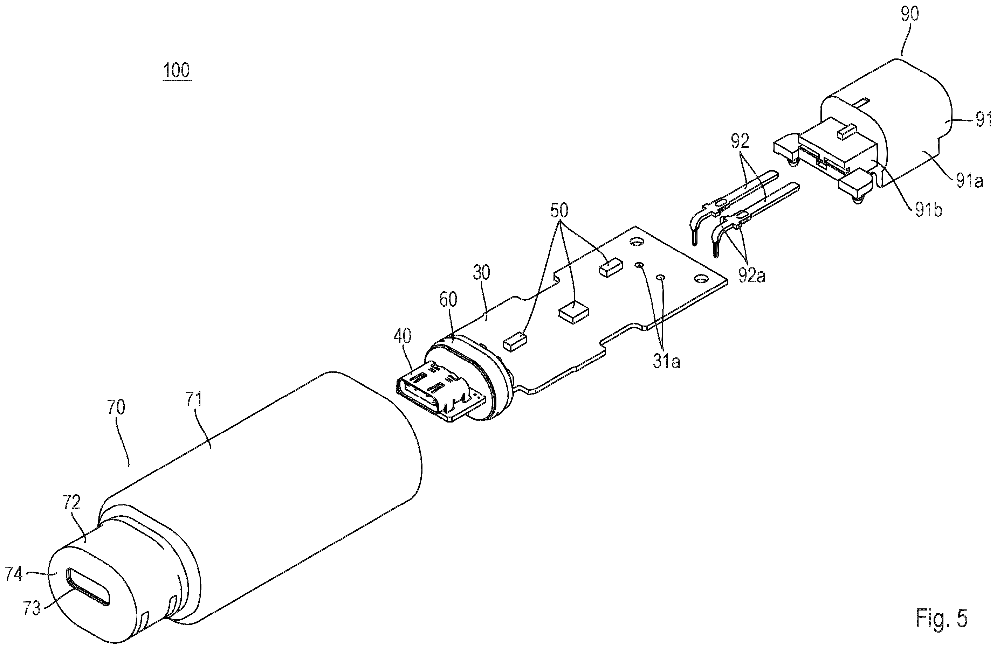

FIG. 3A is a perspective view showing an example of the connector unit as an example of the electronic device according to the present embodiment, and FIG. 3B is a side view thereof, and FIG. 3C is a front view thereof. FIG. 4A is a rear view of the connector unit shown in FIG. 3A, and FIG. 4B is a cross-sectional view taken along a line C-C in FIG. 4A. FIG. 5 is an exploded perspective view of the connector unit shown in FIG. 3A. In FIG. 4A, potting resin 130 described later is not shown, and in FIG. 4B, water guide members 20 and electronic components 50 are not shown.

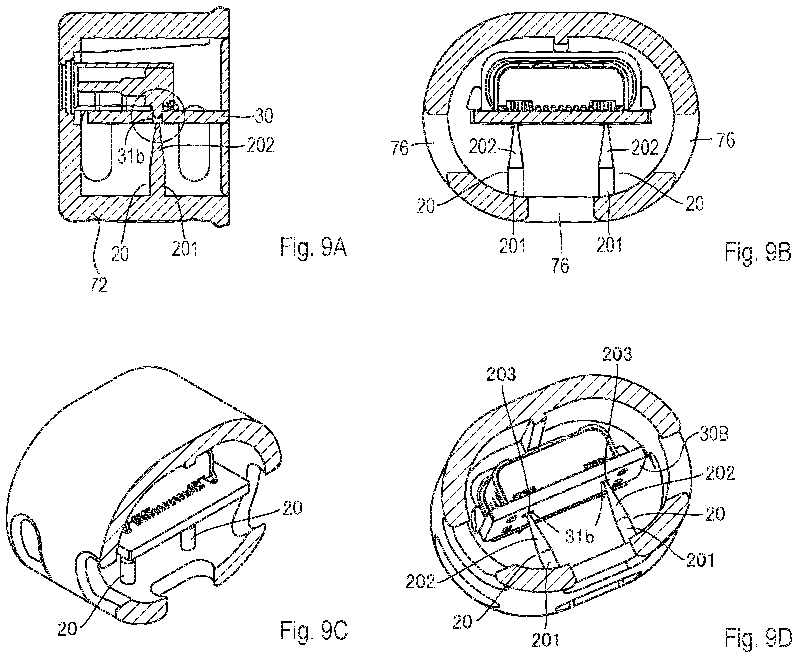

As shown in FIG. 5, a connector unit 100 according to the present embodiment includes a printed wiring board 30, an interface connector 40, electronic components 50, a waterproof sealing member 60, a case 70, and a rear surface connector 90, and is formed with water guide members 20 described later (see FIGS. 9A to 9D) as main elements.

### (Printed Wiring Board 30)

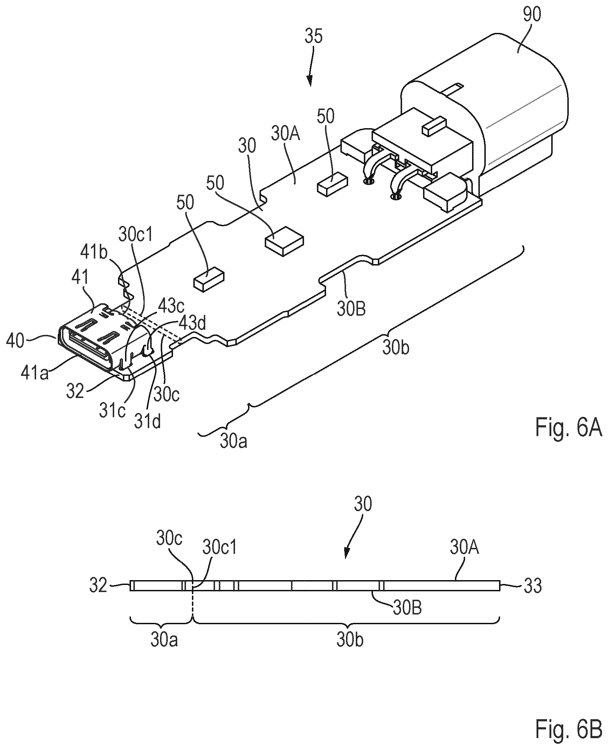

The printed wiring board 30 is a single or multi-layer wiring board that is mainly composed of glass epoxy resin, for example. FIG. 6A is a perspective view showing a printed circuit board 35 of the connector unit shown in FIG. 3A, and FIG. 6B is a side view of the printed wiring board 30 shown in FIG. 6A.

As shown in FIGS. 6A and 6B, the printed wiring board 30 according to the present embodiment has a flat plate shape including an upper surface (also referred to as "first surface") 30A having a substantially rectangular shape and a lower surface (also referred to as "second surface") 30B opposite to the upper surface 30A, and includes an end part 32 including an end surface corresponding to one end in a lengthwise direction, and an end part 33 including an end surface on an opposite side from the end part 32. The printed wiring board 30 includes a first region 30a that extends from the end part 32 in a direction of the end part 33, and a second region 30b that is adjacent to the first region 30a and that extends to the end part 33. When a surface at a boundary between the first region 30a and the second region 30b is defined as a boundary 30c, the first region 30a is a region of the printed wiring board 30 from the end part 32 to the boundary 30c, and the second region 30b is a region of the printed wiring board 30 from the boundary 30c to the end part 33.

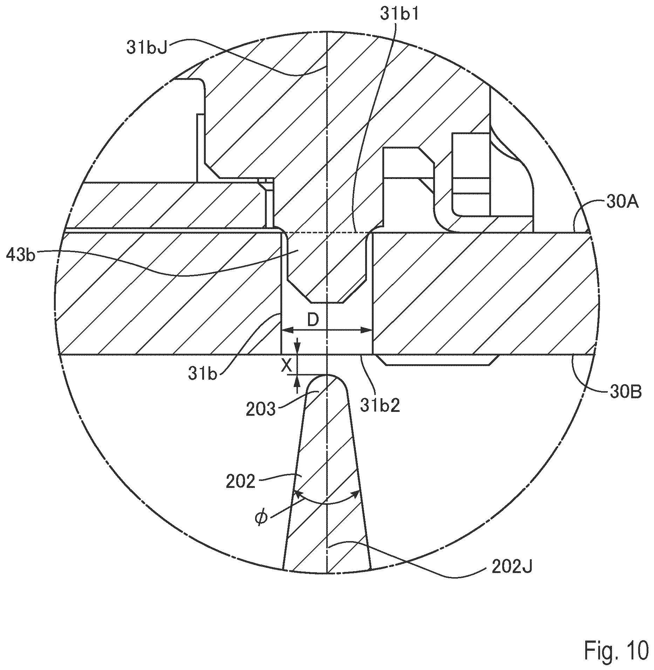

The interface connector 40, the electronic components 50, and the rear surface connector 90 are mounted on the upper surface 30A of the printed wiring board 30. In the present embodiment, the printed wiring board 30 where the interface connector 40, the electronic components 50, and the rear surface connector 90 are mounted will be referred to as "printed circuit board 35". As shown in FIG. 4B, the printed circuit board 35 is housed in the case 70. Additionally, the printed wiring board 30 includes two penetration holes 31b (see FIGS. 9A and 9D). The penetration hole 31b of the present embodiment has a circular hole, and includes two end parts, namely, an end part 31b1 on the upper surface 30A side and an end part 31b2 on the lower surface 30B side (see FIG. 10).

### (Interface Connector 40)

The interface connector 40 to be connected to a connector of a smartphone or the like is mounted on the upper surface 30A of the printed wiring board 30, on the end part 32 side of the first region 30a.

The interface connector 40 is a type of an electronic component. As shown in FIGS. 4B to 6A, a terminal 42 of the interface connector 40 is covered by a metal shell 41 have a non-watertight structure, and is positioned facing outside of the case 70 through an opening portion 73 provided in a front plate part 74 of the case 70. The shell 41 includes a first end part 41a and a second end part 41b. The interface connector 40 includes two protruding parts 43b (see one protruding part 43b shown in FIG. 10) on the end part 41b side of a bottom surface, and includes, on both side surfaces of the shell 41, protruding parts 43c, 43d (FIG. 6A) in this order from the end part 41a side. The protruding part 43b is inserted in the penetration hole 31b provided in the printed wiring board 30. In the same manner, the protruding parts 43c, 43d are inserted in penetration holes 31c, 31d, respectively. When the protruding parts 43b, 43c, 43d are inserted in the penetration holes 31b, 31c, 31d, the interface connector 40 is positioned on the printed wiring board 30. The penetration holes 31b, 31c, 31d are holes penetrating the upper surface 30A and the lower surface 30B of the printed wiring board 30, and are, in this case, formed as non-plated through holes. The interface connector 40 according to the present embodiment is a USB Type-C connector. However, the type of the interface connector 40 is not particularly limited as long as the interface connector is an interface connector having a non-watertight structure. For example, other interface connectors such as a USB Type-A connector or an HDMI (registered trademark) connector may be used. Because the interface connector 40 has a non-watertight structure, even when the interface connector 40 receives water through the opening portion 73, the water is not retained inside the interface connector 40 as long as the water is in small quantity, and the water is discharged outside the interface connector 40.

### (Electronic Component 50)

The electronic components 50, which are surface mount components such as an IC chip and a capacitor, are mounted on the upper surface 30A of the printed wiring board 30, on the second region 30b side. With respect to the electronic components 50 according to the present embodiment, a plurality of electronic components 50 are mounted, as shown in FIG. 6A. The electronic component 50 according to the present embodiment is an electronic component of a different type from the interface connector 40 and the rear surface connector 90 described later. However, the number of electronic components 50 on the printed wiring board 30 is not limited to plural. Moreover, as described later, in the present embodiment, the first region 30a side inside the case 70 is a non-waterproof region, and the second region 30b side is a waterproof region. Accordingly, the electronic components 50 according to the present embodiment may include an electronic component that requires high waterproofness than the interface connector 40. Additionally, in the case where the connector unit 100 of the present embodiment can be implemented without the electronic components 50, the electronic components 50 do not necessarily have to be mounted.

### (Waterproof Sealing Member 60)

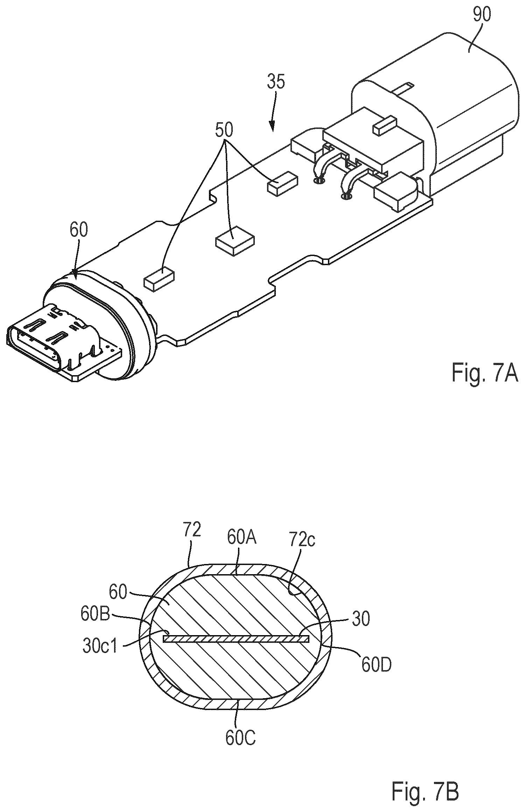

A waterproof sealing member 60 formed from a hot melt material is formed on an outer periphery 30c1 of the boundary 30c of the printed wiring board 30. FIG. 7A is a perspective view of the printed circuit board 35 where the waterproof sealing member 60 is integrally formed. FIG. 7B is a cross-sectional view seen from the interface connector 40 side, where the connector unit 100 is cut along a surface including the boundary 30c. In FIG. 7B, the printed wiring board 30 and the rear surface connector 90 on a backward side (a rear side) of the boundary 30c are not shown.

As shown in FIGS. 7A and 7B, the waterproof sealing member 60 is integrally formed with the printed wiring board 30 by tightly contacting the printed wiring board 30 while extending along and covering the outer periphery 30c1 of the boundary 30c of the printed wiring board 30. As shown in FIG. 7B, the waterproof sealing member 60 formed on the printed wiring board 30 includes pressing surfaces 60A, 60B, 60C, and 60D that press an inner surface of a tubular part 72 when inserted inside the case 70. The pressing surface 60A and the pressing surface 60B, the pressing surface 60B and the pressing surface 60C, the pressing surface 60C and the pressing surface 60D, and the pressing surface 60D and the pressing surface 60A are continuous to each other, and a surface that is continuous as a whole is formed. The pressing surfaces 60A, 60B, 60C, and 60D press an inner periphery 72c that is an inner periphery of the tubular part 72 of the case 70 and that faces toward the outer periphery 30c1, and are thus in close contact with the inner surface of the tubular part 72. When the waterproof sealing member 60 is formed in the above manner, the waterproof sealing member 60 separates inside of the case 70 into the first region 30a side and the second region 30b side.

Furthermore, the second region 30b side of the inside of the case 70 according to the present embodiment is a waterproof region. For example, to achieve the waterproof region, the potting resin 130 is injected or the rear surface connector 90 is provided, as will be described later.

By providing the waterproof sealing member 60 and making the second region 30b side inside the case 70 a waterproof region, a waterproof function is achieved on the second region 30b side even when water enters from a rear end side of the case 70 (a side of the case 70 opposite from the front plate part 74), not to mention a case where water enters through the opening portion 73 of the case 70. Accordingly, the electronic components 50 and the printed wiring board 30 on the second region 30b side inside the case 70 are not affected by water regardless of which orientation the connector unit 100 is attached to another device of a vehicle or the like where the connector unit 100 is mounted.

The waterproof sealing member 60 is integrally formed with the printed wiring board 30 by insert molding, for example. However, the waterproof sealing member 60 is not limited to be formed as one member, and may instead be a plurality of non-annular members that are separately formed from the printed wiring board 30, for example.

### (Case 70)

The printed circuit board 35 where the waterproof sealing member 60 is integrally formed is housed inside the case 70. For example, the case 70 is a molded article formed from thermoplastic resin such as ABS.

As shown in FIGS. 3A to 5, the case 70 includes tubular parts 71 and 72 having rectangular tube shapes, and the front plate part 74 positioned on a front end of the tubular part 72. The tubular part 71 has a tubular shape that is a size larger than the tubular part 72. The opening portion 73 that allows insertion/removal of a mating connector of the interface connector 40 is formed in the front plate part 74 of the tubular part 72. Six drain holes 76 are formed in the tubular part 72, or in other words, on the first region 30a side of the case 70, two each in three directions. The opening portion 73 and the drain holes 76 each communicate with an inner space of the tubular part 72.

Because the drain holes 76 are provided, even if water enters from the opening portion 73 side, the water is not kept retained on the first region 30a side inside the case 70, and is discharged outside the case 70 through the drain holes 76. Because the interface connector 40 has a non-watertight structure, water received by the interface connector 40 is discharged outside the interface connector 40. As a result, the water is temporarily retained on the first region 30a side inside the case 70; however, the water discharged from the interface connector 40 is also eventually discharged outside the case 70 through the drain holes 76. Accordingly, even if a great amount of water is received from the opening portion 73, the water is hardly kept retained on the first region 30a side inside the case 70.

The printed circuit board 35 where the waterproof sealing member 60 is integrally formed is pushed and inserted (inserted under pressure) from a rear end side of the tubular part 71 (opposite side of the case 70 from the front plate part 74), and is housed inside the case 70. As shown in FIG. 4A, sliders 71a, 71b, 71c, and 71d are formed on an inner surface of the tubular part 71, on side surface regions on both left and right sides. When performing push-in insertion of the printed circuit board 35 where the waterproof sealing member 60 is integrally formed into the case 70, an end part of the printed wiring board 30 in a width direction is inserted between the sliders 71a and 71b, and another end part is inserted and pushed in between the sliders 71c and 71d. Accordingly, as shown in FIG. 4B, the interface connector 40, the electronic component 50s, and the waterproof sealing member 60 on the printed wiring board 30, and the rear surface connector 90 excluding a fitting part 91a are housed inside the case 70 together with the printed wiring board 30, at predetermined positions and at predetermined heights.

The inside of the case 70 is separated into the first region 30a side and the second region 30b side by the waterproof sealing member 60. That is, in the case where the waterproof sealing member 60 is used as the waterproof sealing member, the pressing surfaces 60A, 60B, 60C, and 60D of the waterproof sealing member 60 press the inner surface of the tubular part 72, as shown in FIG. 7B. The waterproof sealing member 60 thus separates the inside of the case 70 into the first region 30a side and the second region 30b side.

### (Rear Surface Connector 90)

On the end part 33 side of the second region 30b, the rear surface connector 90 to be connected to a harness connector (not shown) is mounted on the upper surface 30A of the printed wiring board 30. The rear surface connector 90 is a type of an electronic component. As shown in FIG. 5, the rear surface connector 90 includes a housing 91 and terminals 92. The housing 91 has a tubular shape, and is formed from the fitting part 91a to be fitted with the harness connector mentioned above, and a base part 91b that covers a base end of the fitting part 91a. As shown in FIG. 4A, two terminal insertion holes 91c are formed in the base part 91b. The rear surface connector 90 according to the present embodiment includes two terminals 92. The terminal 92 has a shape that is bent in an L-shape, and a pair of protrusions 92a protruding in both sides in a width direction is formed on one side of the L-shape. As shown in FIGS. 4B and 5, the terminal 92 is attached to the housing 91 by having the one side of the L-shape pushed into the terminal insertion hole 91c. The side of the terminal 92 that is pushed in is exposed inside the fitting part 91a so as to be able to be connected to the harness connector mentioned above. The other side of the L-shape of the terminal 92 is inserted and soldered to a through hole 31a provided on the end part 33 side of the printed wiring board 30.

### (Concrete Example 1 for Achieving Waterproof Region: Potting Resin 130)

After the waterproof sealing member 60 and the printed circuit board 35 are housed inside the case 70, the potting resin 130 is injected on the second region 30b side inside the case 70. Examples of a material of the potting resin 130 include, but are not limited to, urethane resin, epoxy resin, and silicone resin. In FIG. 4B, the injected potting resin 130 is indicated using a reference numeral, and is shown with no patterns without using diagonal lines or the like so that the potting resin 130 is distinguishable from the tubular part 71 and the printed wiring board 30. As shown in FIG. 4B, injection of the potting resin 130 is performed until the second region 30b side inside the case 70 is filled with the potting resin 130. Due to being filled with the potting resin 130, the inside of the case 70 may be such that the first region 30a side is a non-waterproof region, and the second region 30b side is a waterproof region.

### (Concrete Example 2 for Achieving Waterproof Region: Rear Surface Cover 80)

Waterproofness may be achieved by placing the second region 30b side inside the case 70 in a hollow state without injecting the potting resin 130, and by providing a rear surface cover 80 on the tubular part 71.

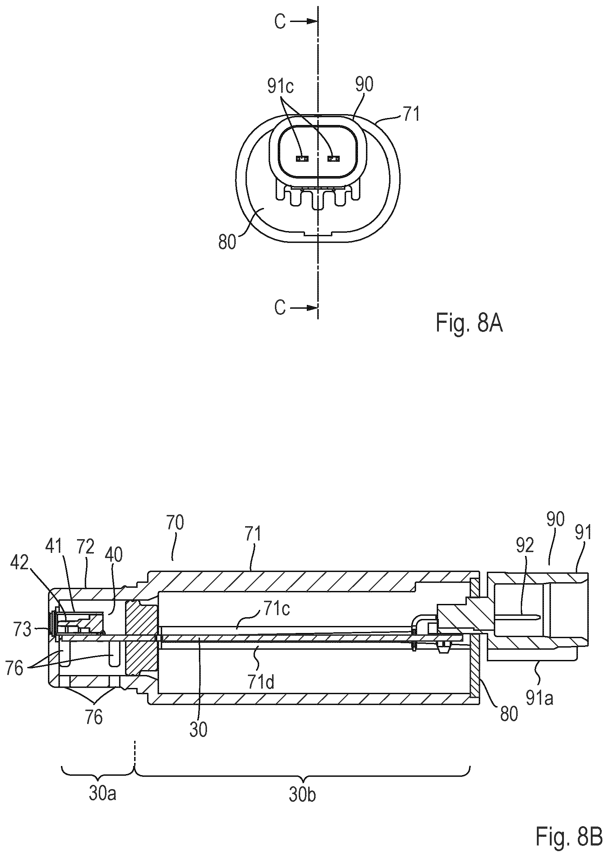

FIG. 8A is a rear view showing an example of the connector unit, where the rear surface cover 80 is included, and FIG. 8B is a cross-sectional view taken along a line C-C in FIG. 8A. In FIG. 8B, the water guide members 20 and the electronic components 50 are not shown. Unlike as in FIGS. 4A and 4B, with the connector unit 100 shown in FIGS. 8A and 8B, the second region 30b side inside the case 70 is not filled with the potting resin 130. Instead, a rear end of the tubular part 71 of the case 70, or in other words, an end part of the case 70 on the second region 30b side is covered by the rear surface cover 80. The rear surface cover 80 includes a circular flat plate having a same shape as an inner diameter of the tubular part 71. A contact part between the rear surface cover 80 and the case 70, or in other words, a part between an inner peripheral surface of a rear end of the tubular part 71 and an outer peripheral surface of the rear surface cover 80, is tightly bonded by an adhesive or the like. By covering the rear end of the tubular part 71 by the rear surface cover 80, a waterproof function is achieved on the second region 30b side inside the case 70.

In the case where the rear surface cover 80 is provided, the rear surface cover 80 may be integrally formed between the fitting part 91a and the base part 91b. The base part 91b is thereby made a part of the rear surface cover 80, and the fitting part 91a is made to protrude rearward from the rear surface cover 80. However, the rear surface cover 80 may instead be formed as a separate body from the rear surface connector 90. For example, the rear surface cover 80 may be formed as a structure that holds the rear surface connector 90. It is conceivable to form the rear surface cover 80 from, but not limited to, a homogeneous material as the waterproof sealing member 60.

Even when the second region 30b side inside the case 70 is made a waterproof region by providing the rear surface cover 80, the second region 30b side inside the case 70 may be filled with the potting resin 130 to further increase the waterproof function. Additionally, in the case where the potting resin 130 is not injected, a moisture prevention coat may be applied on the printed wiring board 30 from the standpoint of waterproofness even when the rear surface cover 80 is provided. As a coating agent, a normal-temperature type fluorine coating agent may be used, or a coating agent that uses urethane-, acrylic-, or silicone-based resin as a film component may be used, for example.

Like the potting resin 130, the rear surface cover 80 may achieve a waterproof function on the second region 30b side inside the case 70, and also, the rear surface cover 80 may achieve the waterproof function at a lower cost than the potting resin 130.

### (Water Guide Member 20)

The water guide members 20 are housed inside the case 70. FIGS. 9A to 9D are diagrams for describing the water guide members 20, and FIG. 9A is a diagram showing a region, on a cross-sectional view A-A in FIG. 3C, from the front plate part 74 to a cross-sectional line B-B in FIG. 3B, FIG. 9B is a cross-sectional view B-B in FIG. 3B, FIG. 9C is a perspective view of FIG. 9B as viewed from upper left, and FIG. 9D is a perspective view of FIG. 9B as viewed from lower left. FIG. 10 is an enlarged view of a region indicated by a dash-dotted line in FIG. 9A. In the present example, as shown in FIGS. 9A to 9D, two water guide members 20 are provided inside the tubular part 72, on the lower surface 30B side of the printed wiring board 30.

Each water guide member 20 is formed from a columnar part 201 having a columnar shape, and a conical part 202 having a conical shape having a side surface that forms an apex angle φ (see FIG. 10), and the water guide member 20 has a protruding shape as a whole. The columnar part 201 forms a base part of the water guide member 20, and is provided in such a way that an axis of the columnar shape extends upright from a bottom surface inside the tubular part 72 toward the lower surface 30B of the printed wiring board 30. The conical part 202 is provided with an upper surface of the columnar part 201 as a start point, and is provided in such a way that an axis of the conical shape extends upright along a same axis as the axis of the columnar part 201 toward the lower surface 30B of the printed wiring board 30. As shown in FIG. 10, an apex of the conical part 202 is formed as a distal end part 203 that is rounded into a semispherical shape. For example, the water guide member 20 may be obtained by injection molding using thermoplastic resin such as ABS, but the material is not limited thereto. The water guide member 20 of the present embodiment is integrally formed with the tubular part 72, but may instead be formed separately from the tubular part 72. In the case where the water guide member 20 is formed separately from the tubular part 72, a bottom surface of the columnar part 201 and the bottom surface inside the tubular part 72 are joined using an adhesive or the like and are fixed to each other to prevent relative movement. Moreover, the water guide member 20 of the present embodiment is solid, but may instead be hollow.

A cross-sectional shape of each of the columnar part 201 and the conical part 202 of the present embodiment is a true circle, but the cross-sectional shape is not limited thereto, and may instead be a different circular shape such as an ellipse or a polygon.

The water guide member 20 is disposed such that the shortest distance to a centroid of a shape of the end part 31b2, on the lower surface (second surface) 30B side, of the penetration hole 31b in the printed wiring board 30 is smaller than a radius of the largest circle that is insertable in the shape of the end part 31b2. For example, when the water guide member 20 is disposed such that an axis 31bJ of the penetration hole 31b and an axis 202J of the conical part 202 are on a same axis, as shown in FIG. 10, the shortest distance between the water guide member 20 and the centroid of the hole in the end part 31b2 (a center of a circle) is a distance X. When a diameter of the circle of the end part 31b2 is given as D, the water guide member 20 is provided at a position where a relationship of X < (D/2) is maintained. By maintaining the relationship of X < (D/2) regardless of whether the axis 31bJ and the axis 202J are on the same axis, at least a part of the water guide member 20 is positioned within a semispherical region protruding downward from the centroid (the center) of the hole of the end part 31b2. Accordingly, at least a part of the water guide member 20 is disposed at a position facing the penetration hole 31b.

Now, a case where the connector unit 100 receives water from the opening portion 73 side and a part of the received water enters the penetration hole 31b in the printed wiring board 30 will be considered. In this case, although the situation may change depending on a size of a diameter of the penetration hole 31b, an amount of received water, and other conditions, the water entering the penetration hole 31b is possibly retained while protruding downward from the end part 31b2. In other words, in the case where a vertically upward force due to surface tension is great, the water may not drip from the printed wiring board 30 in the form of waterdrops, and may stay on the printed wiring board 30 while being exposed below from the printed wiring board 30 in a shape resembling a mountain or a sphere. Particularly, with the connector unit 100 of the present embodiment, the first region 30a side inside the case 70 is a non-waterproof region, and a case is conceivable where the waterproof sealing member 60 acts as a wall and water that is received on the upper surface 30A side of the printed wiring board 30 remains and enters the penetration hole 31b.

With the connector unit 100 of the present embodiment, the water guide member 20 is disposed in such a way that the shortest distance to the centroid of the shape of the end part 31b2, on the lower surface (second surface) 30B side, of the penetration hole 31b is smaller than the radius of the largest circle that is insertable in the shape of the end part 31b2. Accordingly, when water that is received protrudes downward from the end part 31b2, the water comes into contact with the distal end part 203. In this case, the side surface of the conical part 202 having a sloping surface serves as a flow path, and water that was supposed to stay in the penetration hole 31b is made to flow downward. Accordingly, the water guide member 20 may actively discharge water entering the penetration hole 31b in the printed wiring board 30.

A shape of the penetration hole 31b and the shape of the end part 31b2 according to the present embodiment are each not limited to a true circle, and may be another shape such as an ellipse or a quadrilateral. For example, in the case where the shape of the hole of the penetration hole 31b (and the end part 31b2) is elliptical, the water guide member 20 is disposed at a position at which the shortest distance to a centroid of the ellipse (that is, a center of the ellipse) at the end part 31b2 is smaller than a radius of the largest circle (that is, a minor radius of the ellipse) that is insertable in the shape of the end part 31b2. Furthermore, in the case where the shape of the hole of the penetration hole 31b (and the end part 31b2) is a rectangle, which is a type of quadrilateral, the water guide member 20 is disposed at a position at which the shortest distance to a centroid of the rectangle (that is, a center of the rectangle) of the end part 31b2 is smaller than a radius of the largest circle that is insertable in the shape of the end part 31b2 (that is, a length that is half the short side of the rectangle). A quadrilateral here includes a shape that is not exactly a quadrilateral due to four corners being rounded, for example, but that is equivalent to a quadrilateral. Additionally, the following can be said also for first to third modifications described later: (i) there is no restriction on the shape of the hole of the penetration hole 31b (and the end part 31b2) in the printed wiring board 30, and (ii) the water guide member 20 is (a) not limited to a specific material, (b) allowed to be formed separately from the tubular part 72, and (c) allowed to be hollow.

### (First Modification of Water Guide Member)

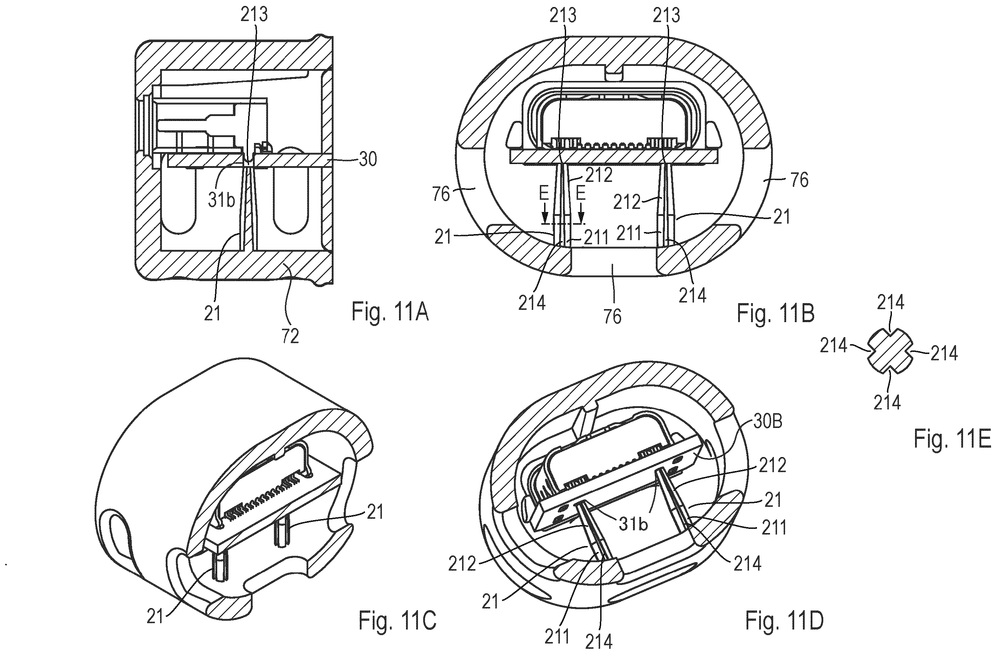

The water guide member 20 described above may be formed as a water guide member 21 as described below. FIGS. 11A to 11E are diagrams for describing the water guide member 21, and FIGS. 11A to 11D are diagrams corresponding to FIGS. 9A to 9D, respectively, and FIG. 11E is a cross-sectional view E-E in FIG. 11B.

In FIGS. 11A to 11E, two water guide members 21 are provided, as in the case of the water guide members 20, and each water guide member 21 is formed from a columnar part 211 and a truncated conical part 212, and has a protruding shape that is disposed at a position facing the penetration hole 31b. That is, when compared with the water guide member 20, the columnar part 211 basically has a same shape as the columnar part 201, but a shape of the truncated conical part 212 is changed from the conical shape of the conical part 202 to a truncated conical shape. Accordingly, the distal end part 203 is not semispherical, and is changed to a distal end part 213 that is formed to be flat. Furthermore, groove parts 214 having a substantially fan-shaped cross section are provided at four positions on the water guide member 21, the groove parts extending between both end parts, or in other words, between an upper end of the truncated conical part 212 and a lower end of the columnar part 211 (FIG. 11E). The groove parts 214 serve to promote downward flow of water by capillary action. Conditions regarding the shortest distance to the centroid of the shape of the end part 31b2 imposed on the water guide member 21 are the same those on the water guide member 20.

Also with the water guide member 21, water entering the penetration hole 31b in the printed wiring board 30 can be actively discharged. Furthermore, because the groove parts 214 are provided, water that is received can be actively guided along a direction of the groove parts 214.

Additionally, when not taking the groove parts 214 into consideration, a cross-sectional shape of each of the columnar part 211 and the truncated conical part 212 of the present embodiment is a true circle, but the cross-sectional shape is not limited thereto, and other circular shapes and polygons may also be adopted.

### (Second Modification of Water Guide Member)

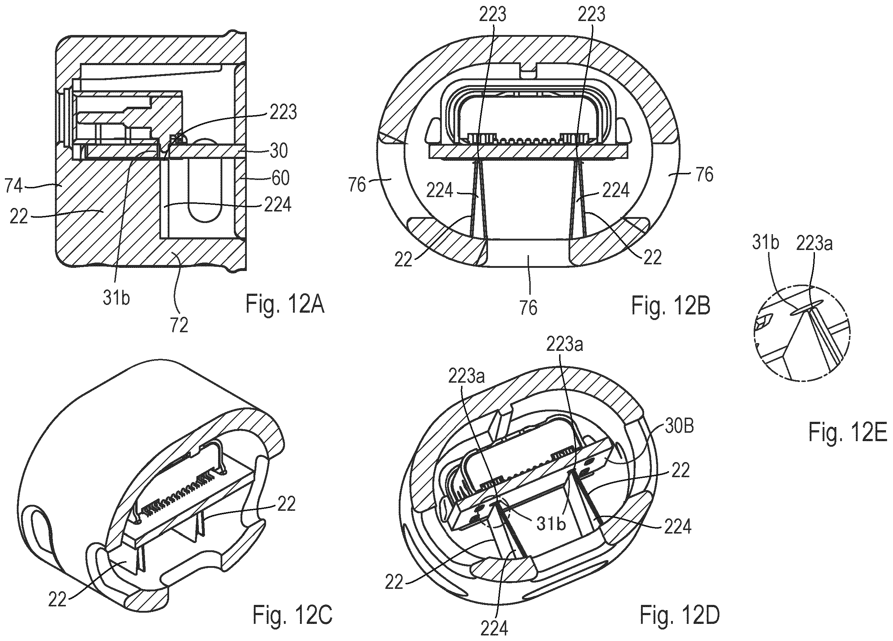

The water guide member 20 described above may be formed as a water guide member 22 as described below. FIGS. 12A to 12E are diagrams for describing the water guide member 22, and FIGS. 12A to 12D are diagrams corresponding to FIGS. 9A to 9D, respectively, and FIG. 12E is an enlarged view of a region indicated by a dash-dotted line in FIG. 12D.

In FIGS. 12A to 12E, two water guide members 22 are provided, as in the case of the water guide members 20, and each water guide member 22 has a shape of a quadrangular prism having base surfaces of an isosceles trapezoid, where one base surface of the isosceles trapezoid is in contact with an inner surface of the front plate part 74 and is provided protruding toward the waterproof sealing member 60 side with the inner surface of the front plate part 74 as a start point (i.e., protruding in a horizontal direction in FIG. 12A). A surface that forms a side surface of the quadrangular prism and that is a surface of the isosceles trapezoid on a lower base side is in contact with a lower surface inside the tubular part 72. A surface that forms a side surface of the quadrangular prism and that is a surface of the isosceles trapezoid on an upper base side is disposed such that one end of the surface in a lengthwise direction ("end part 223a" shown in FIG. 12E) faces the penetration hole 31b in the printed wiring board 30. Accordingly, the water guide member 22 also has a protruding shape that is substantially mountain-shaped relative to the penetration hole 31b.

A groove part 224 having a sideways U-shape cross-section is provided to each end part 223a, from the upper base to the lower base of the isosceles trapezoid (in a vertical direction in FIG. 12B). A size of the sideways U-shape of the groove part 224 is continually increased from the upper base toward the lower base such that a thickness of the groove is constant.

The water guide member 22 uses the end part 223a and its periphery as a part (referred to here as "distal end part 223") corresponding to the distal end part 203 of the water guide member 20. That is, the distal end part 223 including the end part 223a is disposed facing the penetration hole 31b. Conditions regarding the shortest distance to the centroid of the shape of the end part 31b2 imposed on the water guide member 22 are the same those on the water guide member 20.

Also with the water guide member 22, water entering the penetration hole 31b in the printed wiring board 30 can be actively discharged. Furthermore, because the groove part 224 is provided, water that is received can be actively guided along a direction of the groove part 224. Moreover, because the water guide member 22 is in contact with the inner surface of the front plate part 74 and also with the lower surface inside the tubular part 72, the water guide member 22 may serve also as a reinforcement member for the front plate part 74 and the tubular part 72.

### (Third Modification of Water Guide Member)

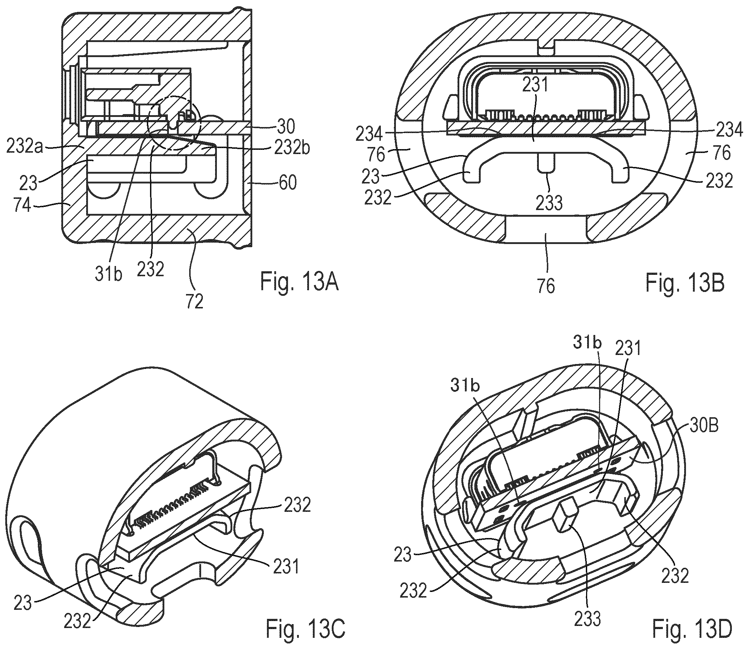

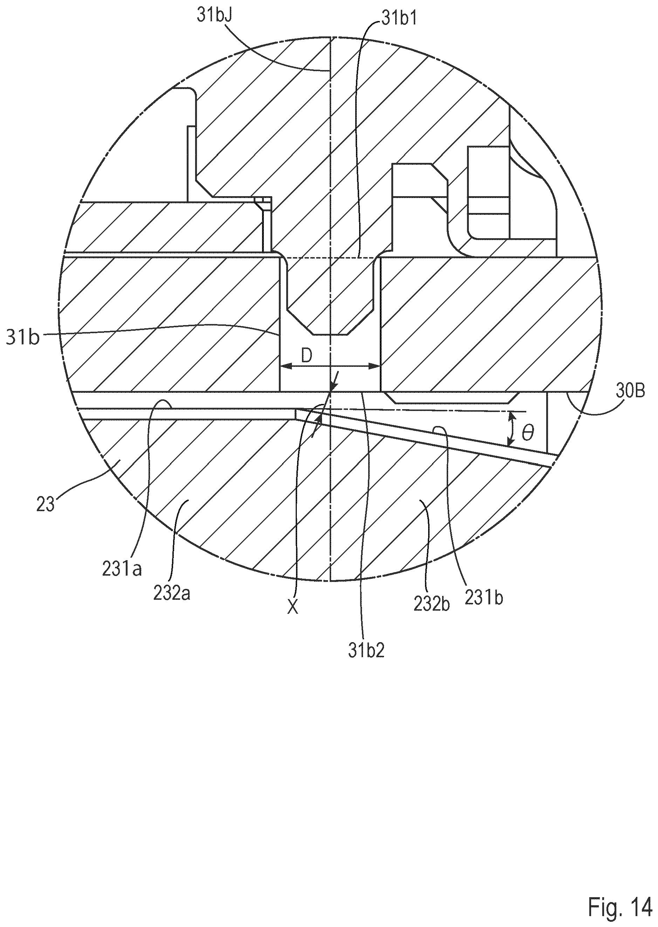

The water guide member 20 described above may be formed as a water guide member 23 as described below. FIGS. 13A to 13D are diagrams for describing the water guide member 23, and are diagrams corresponding to FIGS. 9A to 9D, respectively. FIG. 14 is an enlarged view of a region indicated by a dash-dotted line in FIG. 13A.

As shown in FIGS. 13A to 13D, the water guide member 23 of a present modification is formed to protrude toward the waterproof sealing member 60 side with the inner surface of the front plate part 74 as a start point. The water guide member 23 is formed from a base part 231, two leg parts 232, and a reinforcement part 233. The base part 231 has a flat plate shape that protrudes, in the form of a quadrangular prism having a rectangular bottom surface, toward the waterproof sealing member 60 side with the inner surface of the front plate part 74 as a start point. As shown in FIG. 14, when taking the inner surface of the front plate part 74 as a start point, a thickness of the base part 231 is constant in a region including a surface 231a, and a region including a surface 231b is formed to be thinner, the closer to the waterproof sealing member 60. That is, the surface 231b is sloped away from the lower surface (second surface) 30B at an angle θ relative to the surface 231a. The two leg parts 232 are provided extending in a curved shape from both end parts of the base part 231 in a longitudinal direction. The base part 231 and the two leg parts 232 are continuous, and form a C-shape as a whole. The leg parts 232 each have a shape that protrudes, by a same length as the base part 231, toward the waterproof sealing member 60 side with the inner surface of the front plate part 74 as a start point. A thickness of the leg part 232 is constant in a predetermined region corresponding to the surface 231a, but as with the base part 231, a region corresponding to the surface 231b is formed to be thinner, the closer to the waterproof sealing member 60. The reinforcement part 233 extends, toward the waterproof sealing member 60 side with the inner surface of the front plate part 74 as a start point, in such a way as to reinforce the base part 231 at a center position of the base part 231 in the longitudinal direction. A length of extension is slightly smaller than the base part 231.

Each water guide member 23 is formed on the lower surface 30B side of the printed wiring board 30 below the interface connector 40 in a manner protruding toward the waterproof sealing member 60 side with the inner surface of the front plate part 74 as a start point. Each base part 231 is disposed with at least a part thereof facing the respective penetration hole 31b to serve the role of the distal end part 203 of the water guide member 20 described above.

As shown in FIG. 14, the water guide member 23 includes a sloping surface (the surface 231b) that is at a predetermined angle (90 degrees - θ) relative to a penetration direction of the penetration hole 31b, and is disposed such that the shortest distance to the centroid of the shape of the end part 31b2 (a distance X in FIG. 14) is smaller than the radius of the largest circle that is insertable in the shape of the end part 31b2. That is, in the example in FIG. 14, it is provided at a position where the relationship of X < (D/2) is maintained.

Also with the water guide member 23, water entering the penetration hole 31b in the printed wiring board 30 can be actively discharged. Moreover, a thinned portion of the base part 231, a curved portion of the leg part 232, and a thinned portion of the leg part 232 each serve to guide water in a direction along the portion. Moreover, because the water guide member 23 forms a C-shape by the base part 231 and the leg parts 232 and includes the 233 for reinforcing the base part 231, the water guide member 23 has higher rigidity than the water guide members 20, 21, 23. The water guide member 23 is provided in contact with the inner surface of the front plate part 74. Accordingly, even if a force is applied to the front plate part 74 while a mating connector of the interface connector 40 is being inserted/removed through the opening portion 73, the front plate part 74 is less likely to be deformed or damaged.

Additionally, in the present embodiment, the water guide members 20, 21, 22, 23 are provided facing the two penetration holes 31b in the printed wiring board 30, but depending on conditions such as restrictions inside the case 70, the water guide member 20 may be provided only for one of the penetration holes 31b. It is needless to say the connector unit 100 described in the present embodiment may be changed as appropriate within the scope of the present invention.

### [DESCRIPTION OF REFERENCE NUMERALS]

100: connector unit
20, 21, 22, 23: water guide member
201, 211: columnar part
202: conical part
202J: axis
203, 213: distal end part
212: truncated conical part
214, 224: groove part
223: end part
231: base part
232: leg part
232a, 232b: surface
233: reinforcement part
30: printed wiring board
30A: upper surface
30B: lower surface
30c: boundary
30c1: outer periphery
31a: through hole
31b, 31c, 31d: penetration hole
31b1, 31b2: end part
31bJ: axis
32, 33: end part
35: printed circuit board
40: interface connector
41: shell
41a, 41b: end part
42: terminal
43b, 43c, 43d: protruding part
50: electronic component
60: waterproof sealing member
60A, 60B, 60C, 60D: pressing surface
70: case
71, 72: tubular part
71a, 71b, 71c, 71d: slider
72c: inner periphery
73: opening portion
74: front plate part
76: drain hole
80: rear surface cover
90: rear surface connector
91: housing
91a: fitting part
91b: base part
91c: terminal insertion hole
92: terminal
92a: protrusion
D: diameter
X: distance

## Claims

1. An electronic device comprising:
a printed wiring board having a first surface and a second surface opposite to the first surface, and including a penetration hole that penetrates the first surface and the second surface;
an electronic component mounted on the first surface of the printed wiring board;
a water guide member disposed on the second surface side of the printed wiring board, the water guide member at least partially facing the penetration hole; and
a case that houses the printed wiring board, the electronic component, and the water guide member, wherein
a part, of the water guide member, facing the penetration hole has a protruding shape or includes a surface that is sloped away from the second surface, and the water guide member is disposed in such a way that the shortest distance to a centroid of a shape of an end part of the penetration hole on the second surface side is smaller than a radius of the largest circle that is insertable in the shape of the end part.

2. The electronic device according to claim 1, wherein a shape of a hole of the penetration hole in the printed wiring board is a circle.

3. The electronic device according to claim 1, wherein a shape of a hole of the penetration hole in the printed wiring board is an ellipse.

4. The electronic device according to claim 1, wherein a shape of a hole of the penetration hole in the printed wiring board is a quadrilateral.

5. The electronic device according to any one of claims 1 to 4, wherein the case includes a drain hole that communicates with outside of the electronic device.

6. The electronic device according to any one of claims 1 to 4, wherein
the electronic component is a connector component including a protruding part, and
the protruding part of the connector is inserted in the penetration hole.
